# EUROPEAN PATENT SPECIFICATION

(11) **EP 0 666 596 B1**
(45) Date of publication and mention of the grant of the patent: **14.05.2003**
(21) Application number: 94101661.0
(22) Date of filing: 03.02.1994
(51) Int. Cl.: H01L 27/02, H03K 17/08

(54) **Protection apparatus for series pass MOSFETs**
Schutzapparat für einen seriell-geschaltenen MOSFET
Dispositif de protection pour un MOSFET connecté en série

(43) Date of publication of application: 09.08.1995
(73) Proprietor: Infineon Technologies AG, 81669 München (DE)
(72) Inventor: Krautschneider, Wolfgang, D-85521 Ottobrunn (DE); Killian, Michael, Burlington, VT 05401 (US)

(56) References cited:
- EP-A- 0 385 581
- JP-A- 61 276 249
- US-A- 3 395 290
- US-A- 3 947 727
- US-A- 4 086 642
- PATENT ABSTRACTS OF JAPAN vol. 13, no. 142 (E-739)7 April 1989 & JP-A-63 303 514 (NEC) 12 December 1988

## Description

### FIELD OF THE INVENTION

This invention relates to metal oxide semiconductor field effect transistors (MOSFETs) and, more particularly, to a protection circuit which operates to restrict the voltage across the gate oxide of an input series pass MOSFET to a level which will not cause destruction of the gate oxide.

### BACKGROUND OF THE INVENTION

MOS transistors or the MOSFET are well known. These transistors basically consist of a bar of doped silicon or some other substrate material that acts like a resistor. The terminal into which current is injected is called the source. The source terminal is similar in function to the cathode of a vacuum tube. The opposite terminal is called the drain terminal and can be likened to a vacuum tube plate. In a MOSFET, the polarity of the voltage applied to the drain and source can be changed. The gate electrode basically consists of a conductive area which is overlaid on the oxide covering the entire channel region. The conductive area of the gate in conjunction with the insulating oxide layer and the semiconductor channel forms a capacitor. Hence, by controlling the voltage on the gate electrode, one can control the current flowing between the source and the drain electrodes. Drain current flow is enhanced by the gate voltage and can be controlled or modulated by it. The channel resistance is directly related to the gate voltage. These operations are well known. It is possible to make a MOSFET with a P or N channel by reversing material conductivity types and it is also possible to *form* both p and N channel MOSFETs on the same substrate. This results in the complementary COS/MOS or CMOS types used in digital circuits.

As indicated, many variations of MOS devices exist. A difficulty which the prior art was well aware of concerning MOS devices relates to the protection of such devices. The prior art was aware of the fact that electrostatic discharges occur when an MOS device is picked up by its case and the handler's body capacitance to ground is discharged to ground through the series arrangements of the bulk-to-channel and channel-to-gate capacitances of the device. This appijes to both discrete MOSFETs and complementary MOS ICs. Thus, the prior art taught one to handle such devices fairly carefully to prevent such damage. In any event, because of the static discharge problem, certain manufacturers provided some form of protection for a number of MOS devices. Generally, this protection takes the form of a diode incorporated as part of the substrate material.

By way of background illustration, the gate voltage handling capability of prior art MOS devices is between 30 volts and about 100 volts. Such voltages will not result in breakdown. However, with any MOS device, once the oxide insulation breaks down, the device is usually destroyed. Thus the prior art used a diode in parallel with the input capacitance and this method was employed in single gate MOS devices but had limitations in terms of signal handling as the single diode clips the positive peaks of a sine wave when the device is operated at near zero bias.

The use of a diode, as well as back-to-back diodes, was employed with MOS devices to prevent oxide breakdown for large voltages. The diodes were fabricated by forming a PN junction as part of the monolith chip. This protection scheme was used by many companies, such as Motorola, RCA, and so on in complementary MOS devices. Such protection circuits are well known. See, for example, a text entitled ,,Manual for MOS Users" by John D. Lenk, published by Reston Publishing Company, Inc. (1975). See also U.S. Patent 4,061,928 entitied CIRCUIT ARRANGEMENT FOR THE PROTECTION OF INPUTS OF INTEGRATED MOS CIRCUITS, issued on December 6, 1977 to H. H. Kessier and assigned to Siemens Aktiengesellschaft. This patent describes a circuit arrangement for the protection of inputs of integrated MOS circuits against excessive voltages which may occur due to static charges. The circuit includes a first circuit connected to the MOS circuit and having two bypass circuits reacting at different input voltages, and having a high-ohmic compensating resistance. A second circuit is connected ahead of the first circuit and indudes a bypass circuit and another high-ohmic compensating resistance. The circuit combination operates to protect the input to an inverter stage utilizing a MOSFET as an input transistor and another MOSFET as a load transistor.

U.S. Patent 4,527,213, issued on July 2, 1985, entitled SEMICONDUCTOR INTEGRATED CIRCUIT DEVICE WITH CIRCUITS FOR PROTECTING AN INPUT SECTION AGAINST AN EXTERNAL SURGE to Ariizumi. This patent shows a protection circuit for an MOS circuit which indudes an input terminal having a first resistor connected at one end to the input terminal and a first protective circuit connected between the other end of the first resistor and a reference voltage source for accelerating the discharge of an input surge. The first protective circuit indudes a first MOS transistor and a resistor connected in series to the source-drain path of the first transistor. The first transistor is wired as a diode having its gate electrode connected to the drain electrode, with a second circuit also connected as a diode having its gate electrode connected to the drain electrode, whereby the first and second circuits are separated by a resistor which is used to protect the MOS transistors with regard to large potentials.

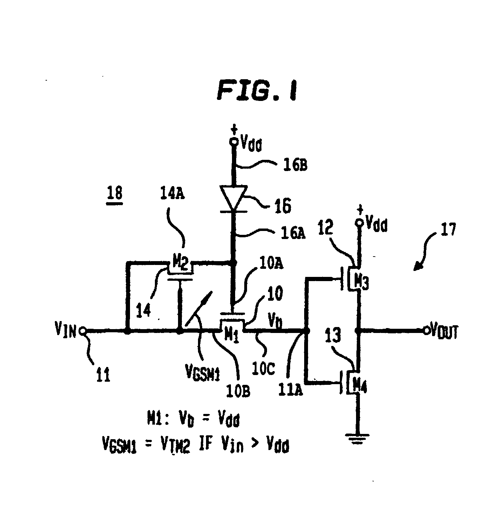

See also U.S. Patent 3,819,952 entitled SEMICONDUCTOR DEVICE, issued on June 25, 1974 to T. Enomoto et al. This patent shows a first protected insulated gate field effect transistor having a drain and a source connected respectively to a gate and source of an FET to be protected against overvoltages, with the gate connected to an input through a resistor. A second protecting FET transistor, higher in threshold voltage than the first transistor, has a source connected to the gate of the first transistor and through another resistor to the source of the same transistor with its gate and drain coupled to the input. The second protecting transistor conducts in response to an overvoltage applied to the input to decrease the voltage applied to the protected transistor and to cause conduction of the first transistor. The conduction of the first transistor causes a voltage at a decreased level to be applied to the protected transistor. The circuit schematic is shown in FIGS. 2, 3, and 4 where field effect transistors are shown with the gate and sources connected together as a diode.

See also U.S. Patent 4,481,521 entitled INSULATED GATE FIELD EFFECT TRANSISTOR PROVIDED WITH A PROTECTIVE DEVICE FOR A GATE INSULATING FILM, issued on November 6, 1984 to K. Okumura. This patent shows an improved protective device for the gate insulation of an integrated gate field effect transistor (IGFET) that does not break down under spike-like input voltages. The protective device is formed on the same semiconductor chip as an operative IGFET and indudes a resistor connected between the input terminal and the operative IGFET's gate. The protection IGFET has the drain and gate both connected to the operative IGFET's gate, and another resistor connected between the protection IGFET's source and a constant voltage source completes the circuit.

The JP-A 61-276249 shows an input protective circuit for protecting an internal circuit against gate voltages close to the supply voltage. A first and a second MOSFET transistor is used as a diode and a series pass-through transistor. The drain of the first MOSFET and the gate of the second MOSFET are connected to a power supply. The inverter, which is built up by MOSFETS, is on the one hand connected to the power supply and on the other hand to ground.

The U.S. Patent 4,086,642 discloses a protective circuit for MOSFETs by using an enhancement-type MOSFET connected as a diode. Hereby, the anode of the enhancement-type MOSFET-diode is connected to the output of a depletion-type MOSFET and the cathode of the MOSFET-diode is connected to ground. The gate of the depletion-type MOSFET is connected to the drain of the same.

The European Patent Application EP-A-385 581 shows an voltage protection system comprising a transmission gate which is connected to the gate of a MOS inverter to be protected.

The U.S. Patent 3,947,727 discloses a protection circuit for insulated-gate FETs, comprising two symmetrical current-carrying paths connected to an inverter. Each path comprises a number of protection diodes.

The above patents and prior art have been cited to acknowledge the fact that there are many prior art disclosures which relate to protection devices and circuits for protecting the gate insulating film to extend the life of the protected field effect device. The prior art is aware that an improved electrical performance of an FET can be had by decreasing the threshold voltage and increasing the voltage gain by making the gate insulating film thinner. However, if the gate insulating film is made thinner, the dielectric breakdown voltage of the gate insulating film is lowered. Thus, it is desirable to keep the gate insulating film as thin as possible but to also provide protection so that the thin gate insulating film is not destroyed during a device over voltage.

There is a particular problem which involves a series pass-through MOSFET which is employed in many MOS circuit configurations. In many system configurations which utilize series pass-through MOSFETs, the circuits employ two different voltages which are supplied from different power suppues. For example, in such a System one may use a 3.3 volt and a 5 volt supply for biasing and providing logic levels. The 3.3 volt power source may not necessarily be an when the 5 volt supply is turned an. This can occur during "Power On" for a short period of time or due to a malfunction of one supply as the lower voltage supply for any given period of time. In this case, the input/output circuits of the 3.3 volt circuit components are biased with 5.5 volts which can cause, in the case of thin gate oxides (those having thicknesses of 10 nm or below), a severe oxide stress with related damage. Prior art techniques do not address themselves to the protection of a MOSFET used as a series pass-through device. Furthermore, one requires a thin oxide and if the oxide were made thicker to avoid the problem, then the device would exhibit lower transconductance leading to decreased circuit performance.

As will be further explained, the present invention allows the use of a thin oxide device with high transconductance in the input/output circuitry in conjunction with a series pass or a pass-through MOSFET.

### SUMMARY OF THE INVENTION

A protection circuit with a protection FET transistor for protecting the input of a series pass-through FET transistor from excessive voltages applied to the source terminal electrode, which is connected to an signal input terminal, or drain terminal electrode, which is connected to an signal output terminal, of the pass-through FET, where said protection FET is connected as a FET diode between said source or drain terminal and the gate electrode of said pass-through FET transistor, comprising a unilateral current conducting device having one terminal connected to the gate electrode of said series pass-through FET transistor, and the other terminal connected to a source of operating potential.

### BRIEF DESCRIPTION OF THE FIGURE

The sole Figure is a detailed circuit schematic showing the invention herein.

### DETAILED DESCRIPTION OF THE INVENTION

Referring to the Figure, there is shown a series pass or a pass-through FET transistor 10. The transistor 10 is a MOSFET. The MOSFET 10 has the source electrode connected to an input pad or terminal 11 designated as Vin. The drain electrode of MOSFET 10 is coupled to the input terminal of a CMOS inverter consisting of transistors 12 and 13, also designated as M3 and M4. The inverter, including transistors 12 and 13, is a well known and standard circuit which is widely employed in FET technology and is utilized as an input buffer or other device. Basically, practically all MOS devices used in digital circuits are some form of complementary inverter. The basic circuit employs a P channel and N channel device formed on a common substrate or chip. The source electrode of the P channel device is connected to the supply voltage (+Vdd) with the source electrode of the N channel device 13 connected to a point of reference potential or ground. The gate electrodes of both channels are tied together and represent the input designated as Vb. The output is taken from the connection between the drain electrodes of the P channel device 12 and the N channel device 13 and is designated as Vout. Thus the inverter shown in the Figure is a very typical and well known inverter and normally operates with logic levels where usually a +V_{b} is a binary 1 and a ground or a zero at V_{b} is a binary 0. With a sufficiently positive input, the P channel section of the substrate has a zero gate voltage and is essentially cut off. The P channel device 12 conducts very little drain current for a FET device and, for example, typically a few picoamperes of leakage current for an enhancement MOSFET. The N channel device 13 or the N channel section of the chip becomes conductive and its drain voltage is near ground or zero. The bad capacitance at the output represents the output bad plus any stray capacitance. With ground potential at the input, the N channel device 13 is cut off and permits only a small amount of leakage drain current to flow. The P channel element becomes conductive, thus making the P channel drain at some voltage near +Vdd. Thus, as one can see, no matter which logic signal is applied at the input or appears at the output, the power dissipation of the inverter is extremely low. This is because both stable states as a 1 or 0 are conducting only a few picoamperes of leakage current, since both channels are in series and one channel is always cut off except very briefly during transition between logic states. Power is dissipated only during switching, making this an ideal situation for logic circuits.

As one can ascertain, the input to the inverter designated as V_{b} is supplied through the series pass MOSFET 10. The MOSFET 10 has a MOSFET 14 (M2) connected as a diode with the drain or source connected to the gate, this diode being connected between the source and gate electrode of the FET 10. The MOSFET 14 has its gate electrode connected to its source or drain electrode to form a diode. Also connected to the gate electrode of FET 10 is a pn diode 16 having its anode electrode coupled to the +Vdd supply with its cathode electrode coupled to the gate electrode of MOSFET 10. An input voltage (Vin) is normally applied at the input terminal 11, which input terminal is connected to the source electrode of the pass-through transistor 10. This voltage causes a voltage drop across the gate oxide of the pass-through transistor 10 which is the difference between the voltage applied to the input terminal 11 and the gate voltage of the pass-through device 10. In order to restrict the oxide voltage to an acceptable value, the MOS transistor 14 is wired as an MOS diode and is connected between the source electrode and gate electrode of the FET device 10. This MOS diode 14 turns on when the voltage across the oxide of the pass-through device 10 exceeds the threshold voltage of the MOS diode 14. In this manner the oxide voltage is limited to an uncritical value for any externally applied voltage or gate voltage of the pass-through device 10. The pn diode 16 is biased in the forward direction from the +Vdd supply to the gate electrode of the pass-through device 10 and operates to suppress leakage current flow from the input via the MOS diode 14 to the +Vdd supply. This action occurs in case of input voltages which are greater than Vdd.

As indicated above, a problem solved by the circuit is as follows. In a system which uses 3.3 volts and 5 volt circuits supplied from different power sources, the 3.3 volt power source may not necessarily be on when the 5 volt supply is turned on. This can occur during Power On for a short period of time or can occur for large periods of time due to a malfunction of the 3.3 volt source. In this case, the input/output circuits of the 3.3 volt components are biased with 5.5 volts (worst case) which can cause, in the case of thin gate oxides, for example, 5 - 25 nm, or thereabouts, a severe stress with consequent damage to the device. Thus in order to protect the gate oxides of the input/output pass-through device 10, the MOS diode 14 is connected between the input/output pad as terminal 11 and the gate electrode of the pass-through MOSFET 10. Thus one can utilize pass-through devices having extremely thin gate oxides and therefore having high transconductance while assuring that the devices will not fail, based on the fact that the voltage across the gate oxide is restricted in value due to the presence of the MOS diode which is connected between the source and gate electrode of the pass-through MOSFET.

Thus as one can ascertain, the above-noted invention enables the use of thin oxide devices for pass-through circuits. As shown basically in the Figure, the voltage designated as VGS <M1> is the voltage between the gate and source electrode of the pass-through transistor 10 and is equal to the MOS diode threshold voltage (VTM2) when the voltage at terminal 11 (Vin) is greater than the operating potential (+Vdd).

The diode 16 is shown in the illustrative embodiment as a PN junction diode, whereas it could be implemented as a MOSFET diode, for example, or as a Schottky diode.

## Claims

1. Protection circuit comprising a protection FET transistor (14) for protecting the input of a series pass-through FET transistor (10) from excessive voltages applied to the source terminal electrode (10B), the source terminal electrode (10B) being connected to a signal input terminal (11) of the pass-through FET transistor, the drain terminal electrode (10C) connected to a signal output terminal (11A) of the pass-through FET transistor, where said protection FET transistor (14) is connected as a FET diode (14A) between said source or drain terminal and the gate electrode of said pass-through FET transistor (10), **characterized by**
a unilateral current conducting device (16) having one terminal (16A) connected to the gate electrode (10A) of said series pass-through FET transistor (10), and the other terminal (16B) connected to an operating potential terminal (Vdd), the unilateral current conducting device (16) being biased in the forward direction when the circuit is connected to a source of operating potential (Vdd).

2. Protection circuit according to Claim 1,
wherein said unilateral current conducting device (16) is a diode having a cathode electrode connected to said gate electrode of said series pass-trough FET (10) and an anode electrode connected to said source of operating potential (Vdd).

3. Protection circuit according to Claim 1 or 2,
wherein said diode (16) is a PN diode.

4. Protection circuit according to one of Claims 1 - 3,
wherein said FETs (10 and 14) are MOSFETs.

5. Protection circuit according to one of Claims 1 - 4,
wherein said gate oxide of said series pass MOSFET (10) is in the order of 10 nm thick.

6. Protection circuit according to one of Claims 1 - 5, further including:
an inverter (17) induding a P and an N channel FET (12 and 13) each having a source, drain and gate electrode, with the source electrode of said P channel FET coupled to said source of operating potential (Vdd), with the drain electrodes of said P and N channel FETs coupled together to an output (Vout), with the source electrode of said N channel FET coupled to a point of reference potential (ground), and with the gate electrodes of said N and P channel FETs (12 and 13) connected together and coupled to said drain electrode (10C) of said pass-through FET (10).

7. Protection circuit according to Claim 6,
wherein said P channel and N channel FETs (12 and 13) are MOSFETs.

8. Protection circuit according to Claim 6 or 7,
wherein said inverter (17), said series pass MOSFET (10), said protection MOSFET (14) and said PN diode (16) are formed on the same substrate (18).

## Patentansprüche

1. Schutzschaltung mit einem Schutz-FET-Transistor (14) zum Schutz des Eingangs eines Reihen-Durchgangs-FET-Transistors (10) vor Überspannungen, die an die Source-Anschlußelektrode (10B) angelegt werden, wobei die Source-Anschlußelektrode (10B) mit einem Signaleingangsanschluß (11) des Durchgangs-FET-Transistors und die Drain-Anschlußelektrode (10C) mit einem Signalausgangsanschluß (11A) des Durchgangs-FET-Transistors verbunden ist, wobei der Schutz-FET-Transistor (14) als eine FET-Diode (14A) zwischen den Source- oder Drain-Anschluß und die Gate-Elektrode des Durchgangs-FET-Transistors (10) geschaltet ist, **gekennzeichnet durch**:
ein einseitig stromleitendes Bauelement (16), von dem ein Anschluß (16A) mit der Gate-Elektrode (10A) des Reihen-Durchgangs-FET-Transistors (10) und der andere Anschluß (16B) mit einem Betriebspotentialanschluß (Vdd) verbunden ist, wobei das einseitig stromleitende Bauelement (16) in Vorwärtsrichtung vorgespannt wird, wenn die Schaltung mit einer Quelle von Betriebspotential (Vdd) verbunden wird.

2. Schutzschaltung nach Anspruch 1, wobei das einseitig stromleitende Bauelement (16) eine Diode ist, deren Kathodenelektrode mit der Gate-Elektrode des Reihen-Durchgangs-FET-Transistors (10) und deren Anodenelektrode mit der Quelle von Betriebspotential (Vdd) verbunden ist.

3. Schutzschaltung nach Anspruch 1 oder 2, wobei die Diode eine pn-Diode ist.

4. Schutzschaltung nach einem der Ansprüche 1 - 3,
wobei die FETs (10 und 14) MOSFETs sind.

5. Schutzschaltung nach einem der Ansprüche 1 - 4,
wobei das Gateoxid des Reihen-Durchgangs-MOSFET (10) eine Dicke in der Größenordnung von 10 nm aufweist.

6. Schutzschaltung nach einem der Ansprüche 1 - 5, weiterhin mit
einem Inverter (17) mit einem p-Kanal- und einem n-Kanal-FET (12 und 13) jeweils mit einer Source-, einer Drain- und einer Gate-Elektrode, wobei die Source-Elektrode des p-Kanal-FET an die Quelle von Betriebspotential (Vdd) angekoppelt ist, wobei die Drain-Elektroden des p- und des n-Kanal-FET zusammen an einen Ausgang (Vout) angekoppelt sind,
wobei die Source-Elektrode des n-Kanal-FET an einen Punkt mit Bezugspotential (Masse) angekoppelt ist und wobei die Gate-Elektroden des p- und des n-Kanal-FET (12 und 13) miteinander verbunden und an die Drain-Elektrode (10C) des Durchgangs-FET-Transistors (10) angekoppelt sind.

7. Schutzschaltung nach Anspruch 6, wobei der p- und der n-Kanal-FET (12 und 13) MOSFETs sind.

8. Schutzschaltung nach Anspruch 6 oder 7, wobei der Inverter (17), der Reihen-Durchgangs-MOSFET (10), der Schutz-MOSFET (14) und die pn-Diode (16) auf demselben Substrat (18) ausgebildet sind.

## Revendications

1. Circuit de protection comprenant un transistor TEC de protection (14) destiné à protéger l'entrée d'un transistor TEC de passage en série (10) contre les tensions excessives appliquées à l'électrode source (10B), l'électrode source (10B) étant connectée à une borne d'entrée du signal (11) du transistor TEC de passage, l'électrode de drain (10C) étant connectée à une borne de sortie du signal (11A) du transistor TEC de passage, dans lequel ledit transistor TEC de protection (14) est connecté comme une diode TEC (14A) entre ladite borne de source ou de drain et l'électrode grille dudit transistor TEC de passage (10), **caractérisé par**
un dispositif de conduction unilatérale du courant (16) comprenant une borne (16A) connectée à l'électrode grille (10A) dudit transistor TEC de passage en série (10) et l'autre borne (16B) connectée à une borne de tension de service (Vdd), le dispositif de conduction unilatérale du courant (16) étant polarisé dans le sens direct lorsque le circuit est connecté à une source de tension de service (Vdd).

2. Circuit de protection selon la revendication 1,
dans lequel ledit dispositif de conduction unilatérale du courant (16) est une diode dont une électrode cathode est connectée à ladite électrode grille dudit transistor TEC de passage en série (10) et une électrode anode est connectée à ladite source de tension de service (Vdd).

3. Circuit de protection selon la revendication 1 ou 2,
dans lequel la dite diode (16) est une diode P-N.

4. Circuit de protection selon l'une des revendications 1 à 3,
dans lequel lesdits TEC (10 et 14) sont des MOSFET.

5. Circuit de protection selon l'une des revendications 1 à 4,
dans lequel l'épaisseur dudit oxyde de grille dudit MOSFET de passage en série (10) est de l'ordre de 10 nm.

6. Circuit de protection selon l'une quelconque des revendications 1 à 5, comprenant en outre :
un inverseur (17) comprenant un TEC à canal P et un TEC à canal N (12 et 13) comprenant chacun une électrode source, drain et grille, l'électrode source dudit TEC à canal P étant couplée à ladite source de tension de service (Vdd), les électrodes drains desdits TEC à canal P et N étant couplées ensemble à une sortie (Vout), l'électrode source dudit TEC à canal N étant couplée à un point de la tension de référence (terre) et les électrodes grilles desdits TEC à canal N et P (12 et 13) étant connectées ensemble et couplées à ladite électrode drain (10C) dudit TEC de passage (10).

7. Circuit de protection selon la revendication 6,
dans lequel lesdits TEC à canal P et N (12 et 13) sont des MOSFET.

8. Circuit de protection selon la revendication 6 ou 7,
dans lequel ledit inverseur (17), ledit MOSFET de passage en série (10), ledit MOSFET de protection (14) et ladite diode P-N (16) sont formés sur le même substrat (18).
